# EUROPEAN PATENT APPLICATION

(11) **EP 4 020 797 A1**
(43) Date of publication of application: **29.06.2022**
(21) Application number: 20856597.8
(22) Date of filing: 05.08.2020
(51) Int. Cl.: H02S 20/20, F16L 59/14

(54) **COMBINED SYSTEM FOR SUPPORTING INDUSTRIAL INSULATION SYSTEMS AND PHOTOVOLTAIC PANELS ON PIPING AND CAPITAL EQUIPMENT**

(30) Priority: 23.08.2019 ES 201930756
(71) Applicant: Aislamientos Suaval, S.A., 33469 Carreño (Asturias) (ES)
(72) Inventor: SUÁREZ-VALDÉS SUÁREZ, José Guillermo, 33469 Carreño (ES)
(74) Representative: Clarke Modet & Co.
(86) International application number: PCT/ES2020/070503
(87) International publication number: WO 2021/038116

(57) **Abstract**

Combined system for supporting industrial insulation systems and photovoltaic plates on pipes and equipment goods, formed by support assemblies (2) along the pipe (1), each assembly having an inner ring (3) that is fixed to the pipe (1) and an intermediate ring (5), joined to the inner ring (3) by means of spacer legs (8), on which the liner (7) of the pipe (1) is arranged, the insulation (6) being between both rings (3, 5). Each assembly has an outer profile (11) connected to the intermediate ring (5) by means of at least one support leg (12) sliding on the outer profile (11) along a guide profile (13). The system has an outer support structure (14) arranged on the outer profiles (11) of the support assemblies (2) along the pipe (1), which will support at least one photovoltaic plate (15).

## Description

### Field of the invention

The present invention refers to the technical field of industrial facilities, pipes, tanks and equipment operating at very high or very low temperatures, such as for example installations for thermal and solar thermal plants, chemical and petrochemical plants, LNG plants and the like, in which pipes, tanks and equipment undergo significant thermal expansions and contractions due to temperature changes during their operation.

The invention relates in particular to support systems for the insulation and coating necessary for pipes and industrial equipment operating at very high or very low temperatures, in order to absorb expansions and contractions while maintaining the necessary insulating and sealing properties, and which can also serve as a support for photovoltaic plates on the pipes and equipment.

### Background of the invention

A very important part of industrial plants, mainly those related to thermal and thermosolar plants, or chemical and petrochemical plants, in general carry out production processes that require very technical and complex industrial insulation systems for pipes, tanks and equipment in general. Especially in power generation plants, almost all pipes and industrial equipment are thermally and/or acoustically insulated.

These insulation systems are mainly made up of three elements: insulation materials, liner materials (metallic or plastic) over the insulation materials, and finally the support systems, which support these insulation and liner materials, avoiding movements and displacements of these, and thus avoiding the creation of air chambers and the entrance of atmospheric agents such as rain or wind to the insulation material, reducing the efficiency of the system and of the plant's production processes.

The support systems have to be dimensioned to support the weight of the insulation, the coating and to absorb the expansions and contractions that occur in the pipes or equipment when subjected to very high or very low temperatures. In addition, these support systems have to facilitate that the insulation and coating materials can absorb these expansions or contractions without deterioration or displacements of the same.

Most industrial plants have thousands of linear meters of pipes and thousands of square meters of equipment goods that require these technical industrial insulation systems.

On the other hand, commercial photovoltaic power plants produce one of the cheapest renewable energies worldwide, competing in investment cost mainly with wind and solar thermal energy. The search for lower investment costs is a constant in the design of the renewable power plants of the future.

Although photovoltaic energy is one of those with the lowest investment costs, it is currently also the one with the least room for improvement, as it has become a very mature technology, in contrast to other less mature and more technically complex renewable energies, which have more avenues of research for reducing investment costs and improving their competitiveness.

In the current commercial photovoltaic power generation plants, the investment consists mainly of the following items:
1. Investment in Industrial Land.
2. Civil works and footings for metallic structure.
3. Metallic structure to support the plates.
4. Photovoltaic plates
5. Wiring systems, converters and instrumentation.
6. Electrical substations

Of the above items, the sum of the first three items represents between 50% and 70% of the total investment cost of the plant. Therefore, a significant reduction in the costs of these items would provide a significant reduction in the investment costs of photovoltaic energy, increasing its profitability. This could be achieved by acting on the ground, i.e., using existing space for other installations. It would also be possible to act on the metal structure that supports the plates, using existing structures as far as possible, with minimal or no adaptations for the support of the photovoltaic plates.

It is therefore desirable to have a system for supporting the insulation and coating of industrial pipes, which meets the requirements indicated above in terms of supporting the insulation and coating, and absorbing expansion and contraction due to large temperature variations, and which also provides a suitable support for solar plates to provide photovoltaic energy at a minimum investment cost and therefore with high profitability.

### Summary

The present invention achieves the objective indicated above by means of an insulation and coating support system for industrial pipes, formed by a plurality of support assemblies arranged along the length of the pipes to be insulated.

Each support assembly has an inner ring for fastening to the pipe, and an intermediate ring, concentric outside the inner ring and connected to it by means of a plurality of spacer legs. In this way, the pipe insulation will be arranged between the inner ring and the intermediate ring of the support assemblies, and the pipe coating will be arranged over the intermediate ring. The spacer legs have expansion and contraction absorbing means to absorb the expansion and contraction caused by temperature changes in the pipes. This system of rings allows to improve the fixation of each set of supports to the pipes, and to lodge between both the insulation of the pipes.

In addition, the support assemblies have an outer profile that is joined to the intermediate ring by means of at least one support leg. This leg, or legs, are movable in the outer profile along a guide profile that is arranged in said outer profile, in order to adapt to the different diameters and changes in dimensions of the pipes and equipment, and to absorb dilatations.

The industrial pipes insulation and coating support system of the present invention has an outer support structure arranged on the outer profiles of the support assemblies along the pipes, which acts as a support for the photovoltaic plates, and may also support the movement mechanism and solar tracker in case the photovoltaic plates are mobile.

This support system is installed on industrial pipes and equipment that conduct or store industrial fluids (liquids or gases) at very high or very low temperatures. These pipes require the installation of insulation and coating systems, as well as sometimes the installation of an electrical wiring system surrounding the pipes or equipment, to provide heat to the fluid circulating inside. This system of insulation support and pipes liner will in turn serve to support a set of photovoltaic plates on the outside of the insulation liner, with the aim of achieving a commercial photovoltaic plant drastically reducing the initial investment cost in industrial land, civil works, and metal structure to support the photovoltaic plates, compared to a traditional commercial photovoltaic plant and will allow the installation of supports on the pipes without damaging the electrical wiring systems that are required.

In this case, the new system will take advantage of the industrial floor, the civil works and the metallic structure that the pipes and industrial equipment already require in order to fix fixed or mobile photovoltaic plates on top of the insulation and liner system of these pipes and equipment on the upper part of the insulation system.

In this way, taking advantage of the insulation support systems that are required in industrial plants, and considering that to support the pipes and equipment the purchase of the industrial floor, the civil works, the footings and the metallic structure has already been made, and designing this new support that serves at the same time to support the insulation and coating systems, and also the photovoltaic plates on the outside of this system, it is possible to install a photovoltaic commercial plant, a commercial photovoltaic plant can be installed with a reduced investment cost of between 50% and 70% over a conventional commercial photovoltaic plant, and the photovoltaic energy generated can be used to cover part or all of the energy consumption of the industrial plant, or to be sent to the central energy network or to feed energy storage systems for various uses.

Thus, this new solution consists of the development of a new support system designed and dimensioned to replace the traditional support systems of the insulation and industrial coating systems, by one that in addition to fulfilling this goal also serves to fix photovoltaic plates, fixed or mobile, on the upper exterior part of pipes and industrial equipment. This system allows the absorption of the expansions or contractions that may occur in the insulated pipes or industrial equipment, so that the photovoltaic plates arranged on the system do not suffer movements produced by the expansion or contraction of the pipes or equipment.

According to a particular embodiment of the invention, the inner ring may be made in a single piece, although typically it is composed of two parts which can be coupled together by means of coupling means, which facilitates their installation and removal from the pipes. Preferably these coupling means may be dowel screws, which ensure a fast and reliable fastening to the pipe.

According to a preferred embodiment of the invention, the inner ring has expansion and contraction absorption means, several of which may be present at different points along its length. The purpose of these is to absorb the expansions or contractions that occur in the inner ring due to the expansions or contractions produced in the pipe, preventing the outer photovoltaic plates from suffering such expansions or contractions. Preferably, these expansion and contraction absorption means present at least one fold and a cut, or an intermediate curving, in the inner ring in order to be able to absorb the changes in dimensions due to expansions and contractions.

Preferably, the inner ring presents on its inner face a plurality of tubular sections, or metallic squares, to facilitate the passage of electrical wiring without this being damaged by the support and insulation systems when the plant is in operation and these have to withstand contractions and/or expansions. Thus, all electrical wiring systems will pass through them and will not be damaged by possible movements of the inner ring. The length of these tubular sections is the same as the width of the inner ring, and through them the inner ring is fixed to the pipe.

In particular, the intermediate ring may be made in a single piece, although it will typically consist of two or more two parts which can be coupled together, thus facilitating installation and removal.

### Brief description of the drawings

In the following, in order to facilitate the understanding of the invention, by way of illustration but not limitation, an embodiment of the invention will be described with reference to a series of figures.
Figure 1 shows a schematic perspective view of an insulation and coating support system subject of the present invention arranged on a pipe, and with solar plates arranged thereon. Figure 1 presents a portion in exploded view to show the inner elements.
Figure 2 is a section view of the support system of figure 1, showing its main elements.
Figure 3 is a detail view of A of figure 2, consisting of a particular embodiment of the inner ring expansion and contraction absorption means.

In these figures reference is made to a set of elements which are:
1. pipes
2. support assembly
3. inner ring
4. coupling means of the different parts of the inner rings.
5. intermediate ring
6. pipe insulation
7. pipe liner
8. spacer legs
9. expansion and contraction absorption folds
9'. expansion and contraction absorption cut
10. tubular sections
11. outer profile
12. support legs of the outer profile
13. guide profile of outer profile
14. outer support structure
15. photovoltaic plate
16. rivets for joining the support legs to the intermediate ring.

### Detailed description of the invention

The object of the present invention is a system for insulation support and coating of industrial pipes.

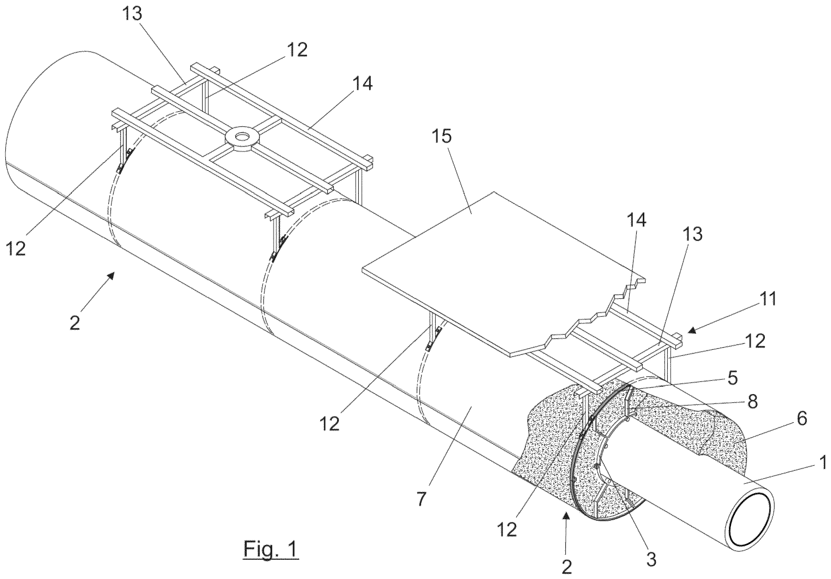

As can be seen in figure 1, the system is formed by a plurality of support assemblies 2 arranged along the length of the pipe 1 to be insulated.

As can be seen in the figures, each support assembly 2 has an inner ring 3 for attachment to the pipe 1, and an intermediate ring 5, which is concentric outside the inner ring 3 and is attached to it by means of a plurality of spacer legs 8, or bolts, which have expansion and contraction absorbing means for absorbing expansion and contraction caused by temperature jumps in the pipe 1. By means of this configuration, the insulation 6 of the pipe 1 will be arranged between the inner ring 3 and the intermediate ring 5 of the support assemblies, and the liner 7 of the pipe 1 will be arranged over the intermediate ring 5. The length of the spacer legs 8 will be at least that of the thickness of the insulation 6 required, so that it can be properly housed between the inner ring 3 and the intermediate ring 5.

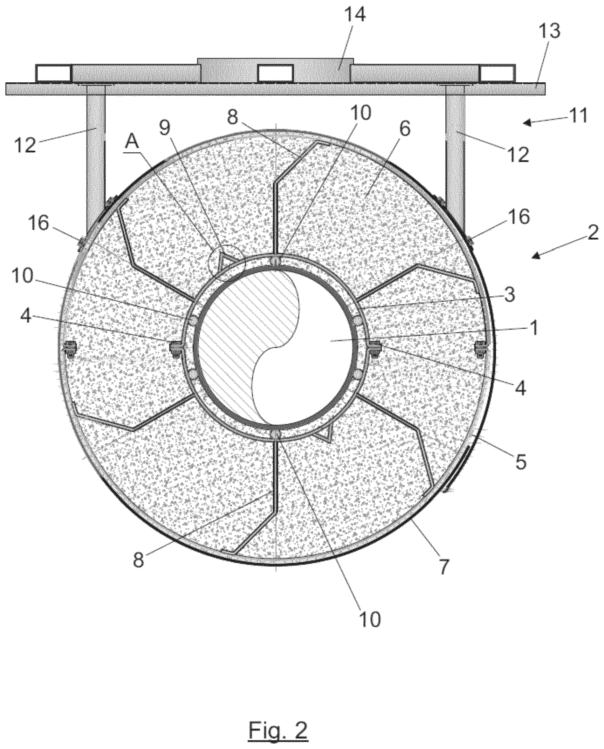

The figures show an embodiment with two support legs 12. This support leg, or legs, 12 are fixed to the intermediate ring 5 by means of screws or rivets 16, as can be seen in figure 2. The support legs 12 are movable on the outer profile 11 along a guide profile 13 which is arranged on said outer profile 11.

The support system object of the present invention has an outer support structure 14 which is positioned on the outer profiles 11 of the support assemblies 2 along the pipe 1, which acts as a support for at least one photovoltaic plate 15, as can be seen in the figures.

The inner ring 3 may be made in a single piece, although as shown in figure 2, in particular it may be formed by at least two parts which can be coupled together by means of coupling means 4. Preferably these coupling means 4 may be dowel screws, as can be seen in figure 2.

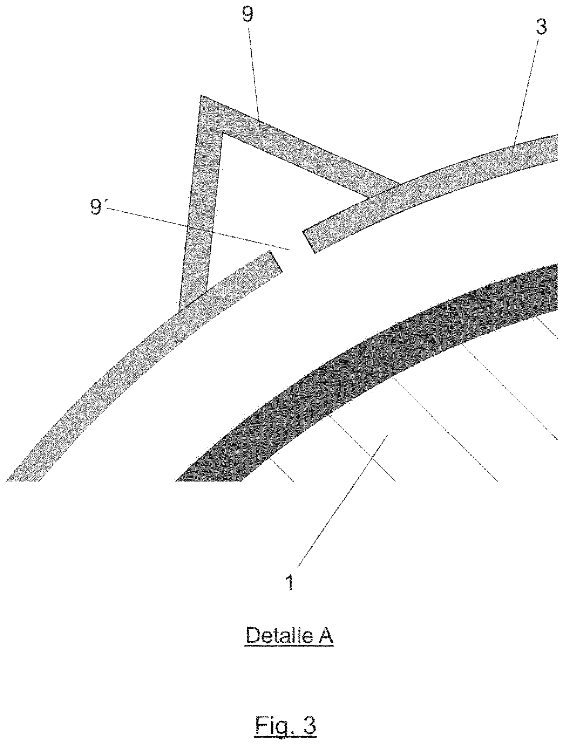

According to a preferred embodiment of the invention, the inner ring 3 has dilatation and contraction absorption means. Figure 3 shows a particular embodiment of these dilatation and contraction absorption means, which have at least one fold 9 and one cut 9' in the inner ring 3 in order to be able to absorb changes in dimensions.

Preferably, the inner ring 3 presents on its inner face a plurality of tubular sections 10 for the passage of electrical wiring.

The intermediate ring 5 may be made in a single piece, although according to a particular embodiment shown in figure 2, the intermediate ring 5 may be formed by at least two parts which ends can be welded, screwed or riveted together, which facilitates its installation and removal.

## Claims

1. Combined system for supporting industrial insulation systems and photovoltaic plates on pipes and equipment goods, comprising a plurality of support assemblies (2) arranged along the length of the pipe (1), wherein
- each support assembly (2) comprises
- an inner ring (3) configured to be fixed to the pipe (1),
- an intermediate ring (5), concentric outside the inner ring (3) and joined to it by means of a plurality of spacer legs or bolts (8) comprising expansion and contraction absorbing means, the liner (7) of the pipe (1) being arranged on the intermediate ring (5), and the inner ring (3) and the intermediate ring (5) being configured to house between them the insulation (6) of the pipe (6),
- and an outer profile (11) connected to the intermediate ring (5) by means of at least one support leg (12), said support legs (12) being movable on the outer profile (11) along a guide profile (13) arranged on said outer profile (11),
- and because the system comprises an outer support structure (14) arranged on the outer profiles (11) of the support assemblies (2) along the pipe (1), and configured to support at least one photovoltaic plate (15).

2. Combined system for supporting industrial insulation systems and photovoltaic plates on pipes and equipment goods, according to claim 1, wherein the inner ring (3) is formed by at least two parts which ends can be coupled together by means of coupling means (4).

3. Combined system for supporting industrial insulation systems and photovoltaic plates on pipes and equipment goods according to the preceding claims, wherein the coupling means (4) comprise dowel screws.

4. Combined system for supporting industrial insulation systems and photovoltaic plates on pipes and equipment goods, according to any of the preceding claims, wherein the inner ring (3) comprises expansion and contraction absorption means.

5. Combined system for supporting industrial insulation systems and photovoltaic plates on pipes and equipment goods according to the preceding claims, wherein the expansion and contraction absorption means comprise at least one fold or bend (9) and a cut (9') in said inner ring (3).

6. Combined system for supporting industrial insulation systems and photovoltaic plates on pipes and equipment goods according to any of the preceding claims, wherein the inner ring (3) is configured to be fixed to the pipe (1) by means of a plurality of tubular sections (10) configured for the passage of electrical wiring.

7. Combined system for supporting industrial insulation systems and photovoltaic plates on pipes and equipment goods, according to any of the preceding claims, wherein the intermediate ring (5) is formed by at least two parts which ends are couplable to each other.
